# EUROPEAN PATENT APPLICATION

(11) **EP 0 575 969 A2**
(43) Date of publication of application: **29.12.1993**
(21) Application number: 93109971.7
(22) Date of filing: 22.06.1993
(51) Int. Cl.: G11C 27/04, G11C 11/56

(54) **Memory device**

(30) Priority: 23.06.1992 JP 189864/92
(71) Applicant: YOZAN INC., Tokyo 155 (JP); SHARP KABUSHIKI KAISHA, Osaka 545 (JP)
(72) Inventor: Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

The present invention has an object to provide a memory device for preventing data circulating on a plural number of linear CCD array from getting worse, for accessing data in high speed, and for reduce the consumptive electric power.

A memory device of this invention realizes to downsize a block of cell by means of circulating data on a plural number of linear CCD arrays which is for storing data by electric charge on a cell and keeping analog data, which sets a clock generation means for circulating data on all arrays and another clock generation means for circulating in high speed only the array loops having necessary data.

## Description

### FIELD OF THE INVENTION

The present invention relates to a memory device, especially to that effective for storing analog data or multilevel data.

### BACKGROUND OF THE INVENTION

The reason why a digital computer has made progress as a programmable computer can be conceived that the size and the capacity of a digital memory has rapidly advanced into small and large, respectively, than an analog memory. But recently, it is close to the limit to produce higher density of digital LSI: the development of a digital computer has the limit without doubt. Conventionally, the scale of a circuit is large and the process of the production is complicated in order to realize a memory in analog or in multilevel.

A method is contrived for downsizing a block of cell keeping analog data by means of the circulation of data on a plural number of linear CCD arrays in order to solve the problem. However, this method has a problem that data is worse when circulation speed is slower, and that necessary electric power increases when circulation speed is faster so as to prevent the data getting worse and access the circulating data in high speed.

### SUMMARY OF THE INVENTION

The present invention solves the above-mentioned problems of the prior art and has an object to provide a memory device for preventing data circulating on a plural number of linear CCD array from getting worse, for accessing data in high speed, and for reduce the consumptive electric power.

A memory device of the present invention makes it possible to prevent data from getting worse, access to data in high speed and reduce the consumptive electric power by setting i) a clock generation means for circulating data on all arrays by realizing to downsize a block of cell by means of circulating data on a plural number of linear CCD arrays and keeping analog data, and ii) another clock generation means for circulating in high speed only the array loops having necessary data.

### BRIEF DESCRIPTION OF THE DRAWINGS

Figure 1 shows a block diagram of an embodiment of a memory device according to the present invention.

Figure 2 shows a block diagram of a loop array of a CCD of the embodiment in Figure 1.

Figure 3 shows a block diagram of a cache memory of the embodiment in Figure 1.

Figure 4 shows an image of an address register of the embodiment in Figure 1.

### PREFERRED EMBODIMENT OF THE PRESENT INVENTION

Hereinafter, an embodiment of a memory device according to this invention is described with reference to the attached drawings.

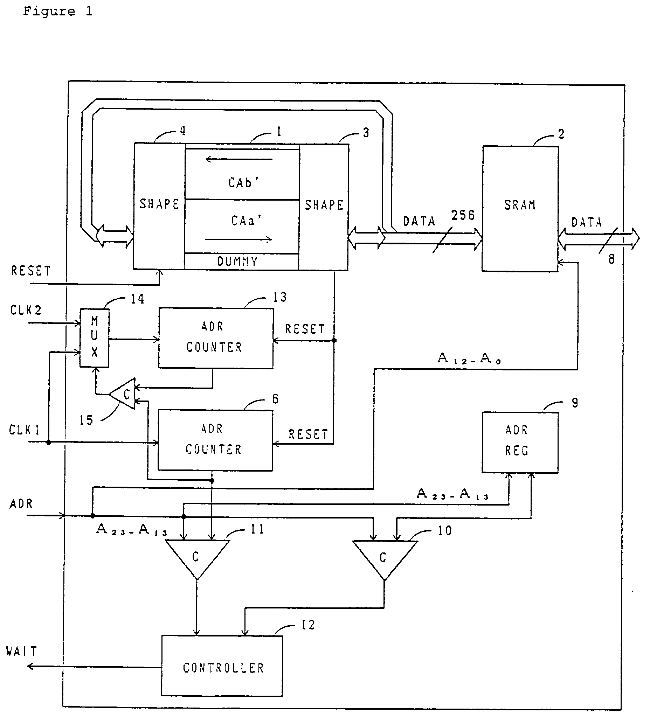

Figure 1 shows the whole circuit of the memory device. It comprises main memory 1 and cache memory 2, both of which are composed of CCD arrays.

In main memory 1, a plural number of looped CCD array "L" are connected in parallel. The CCD array is connected CCD array CAa by looping. The set of CCD array CAa and CAb are expressed by CAa' and CAb', respectively, in Figure 1. CCD array CAa transmits data to the end direction keeping the data, and CCD array CAb returns data to the start point keeping the data. It means that the CCD array keeps data in whole of the circular root and has the capacity for twice scale of data than that for storing data in one way. It is also possible to simplify the circuit by forming the return root by simple conductor.

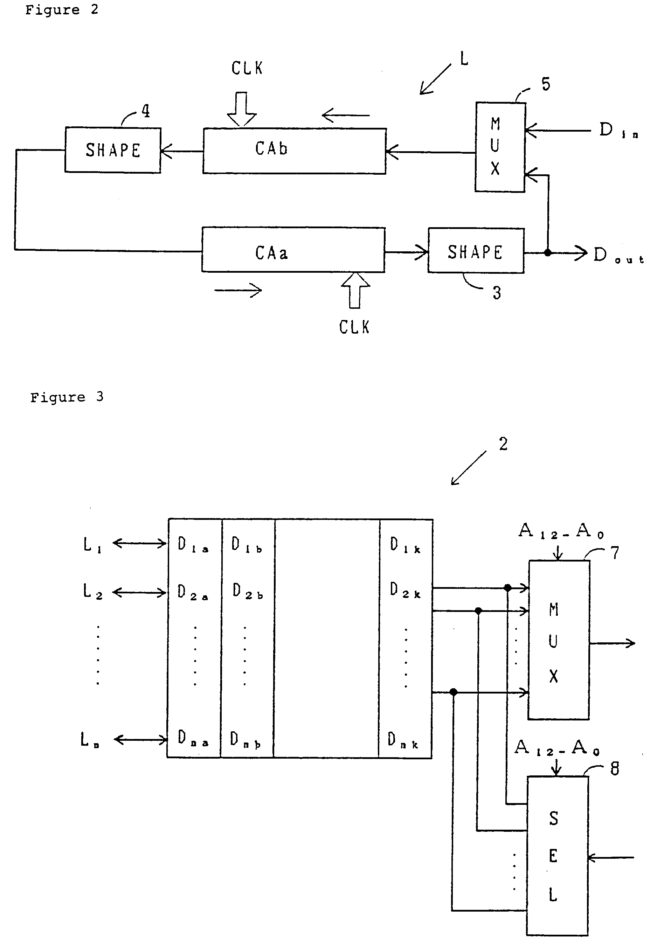

In Figure 2, shaping circuits 3 and 4 are connected to the end points of CCD arrays CAa and CAb, respectively. Worsened data (whose level got poor) is restored by the A/D converting function of the shaping circuits. The output of shaping circuit 3 is connected to CCD array CAb through 2 inputs multiplexer 5 and is able to write new data from Din. Branch Dout is set on the output of shaping circuit 3. Data can be read from the branch Dout. It is shown in Figure 1 by "DATA". Generally, a CCD has more simpler structure than a cell of an usual DRAM. The necessary area for the storage of 1 datum is small and analog data can be stored in a cell. Therefore it is possible to realize a memory with more larger capacity by CCD than that of general DRAM.

Cache memory 2 is a high speed RAM for once storing data to read and write from/to main memory 1 (SRAM is usually used). As shown in Figure 3, it comprises row address from L1 to Ln of the numbers corresponding to each CCD array loop "L". It means that a unit of data of all array loops can be simultaneously transmitted from main memory 1 to cache memory 2, and vice versa. High speed of transmission is guaranteed by it.

The data of CCD array is transmitted by transmission clock and circulates on loop array.

The transmission clock for the circulation is set more than the predetermined value so as to prevent data from getting worse. Clock CLK1 of rather low speed is used for usual circulation. On accessing data, high speed clock CLK2 is used in order to read and write data in high speed.

Clocks CLK1 and CLK2 are generated by independent clock generation means, and input to the memory device. The clocks CLK1 and CLK2 are to be selectively input to CCD array CAa and CAb, and selectively input to address counter 13 through multiplexer. Clock CLK1 is input to address counter 6 and controls address of the data of each CCD array when data is transmitted for usual refreshment. As multiplexer 14 input clock CLK1 to address counter 13, address counter 6 and 13 synchronously count the same number.

When a CCD array requires to read or write data, clock CLK2 is input to the CCD array which is transmitted in high speed. Multiplexer 14 input clock CLK2 to address counter 13, and controls in address counter 13 to only address on the CCD array transmitted in high speed. As other CCD arrays are transmitted in low speed by clock CLK1, the consumptive electric power is a little in whole of the memory device. When writing or reading data is completed, the counted value by address counters 6 and 13 are compared in comparator 13 and clock CLK2 is input to address counter 13 until the 2 values are the same. When the 2 values counted by the both counters are the same, multiplexer 14 inputs CLK1 instead of CLK2 to address counter 13: consequently address counters 6 and 13 return to the synchronous count.

The address of a CCD array is always controlled by address counter. In order to verify it, a dummy CCD array loop is set in the main memory (shown by "DUMMY" in Figure 1) and the address of the main memory is registered on the array.

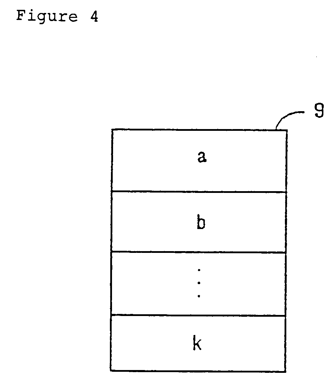

The addresses of multiplexer 7 and selector 8 are designated by inputting upper bits from A₂₃ to A₁₃ of ADR from outside of the device. As these upper bits address are simultaneously input to address register 9, the address of the data stored in the cache memory can be identified by checking the content in the address register. The check is executed by comparator 10 which is set by the same number of the addresses to be stored ("k", in Figures 3 and 4). The lower bits of ADR from A₁₂ to A₀ designated column addresses corresponding to the data of each row address. Reading and writing to a cache memory from outside is performed with respect to the designated column address.

When data is read and data does not exist in cache memory 2, it is necessary to write the required data in the cache memory after the data of transmitted to the end of CAa in main memory 1. Consequently, the address counter is input in comparator 11 and it is compared with A₂₃ to A₁₃.

When data is written and data does not exist in memory 12. only the column address of new data is overwritten on the oldest data in the cache memory, the required data in row address is transmitted to the cache memory from the main memory with the written address masked, and the composed data is back to the main memory.

The output of comparator 10 and 11 is input to controller 12. A wait signal WAIT is output from controller 12 in order to keep the waiting time for accessing a cache memory and for bringing data in case of no data is in a cache memory.

As mentioned, the memory device according to the present invention realizes the small scale cell by means of storing analog data by circulating data on a plural number of linear CCD array, makes it possible to access in high speed by reading and writing data through cache memory, and by registering on an address register the address of the data in cache memory. Therefore, it is possible to realize an analog memory or a multivalue memory with a small circuit. Also it is possible to reduce consumptive electric power by circulating in high speed only the required data when it is necessary, and circulating other unnecessary data in the minimum speed for preventing getting worse.

## Claims

1. A memory device comprising:
i) a plural number of CCD arrays having cells for storing data as an electrical charge thereon;
ii) the first transmission clock generating means for constantly generating the first transmission clock for successively transmitting data of each cell in said CCD array;
iii) the second transmission clock generating means for generating the second transmission clock for transmitting data of one of said CCD arrays in higher speed than said fast transmission clock;
iv) a shaping circuit for shaping data on the end of CCD array;
v) a feedback line for feeding shaped data back to the beginning end of said CCD array;
vi) a cache memory comprising row addresses corresponding to said CCD arrays;
vii) the first address counter for designating a location of data on CCD array as column address by counting said first transmission clock;
viii) the second address counter for designating a location of data on CCD array as column address by counting said second transmission clock;
ix) an address register for registering a column address of data registered in said cache memory; and
x) the first comparator for comparing said column address in said address register with an address newly input.

2. A memory device as claimed in Claim 1, further comprising a comparator for comparing counted values of said first address counter and said second address counter.
